# EUROPEAN PATENT APPLICATION

(11) **EP 4 321 295 A1**
(43) Date of publication of application: **14.02.2024**
(21) Application number: 22784355.4
(22) Date of filing: 21.02.2022
(51) Int. Cl.: B24B 7/17, B24B 37/08, H01L 21/304

(54) **WAFER PROCESSING METHOD AND WAFER**

(30) Priority: 07.04.2021 JP 2021065465
(71) Applicant: Shin-Etsu Handotai Co., Ltd., Tokyo 100-0004 (JP)
(72) Inventor: YOSHIDA, Yasuki, Nishishirakawa-gun, Fukushima 961-8061 (JP); TAGA, Ryo, Nishishirakawa-gun, Fukushima 961-8061 (JP)
(74) Representative: Mooser, Sebastian Thomas
(86) International application number: PCT/JP2022/006800
(87) International publication number: WO 2022/215370

(57) **Abstract**

The present invention is a method for processing a wafer including; surface-grinding front surface of the wafer and back surface opposite to the front surface with a grindstone having a size of 10000 or more and, double-side polishing both sides of the wafer that has been surface-ground so that removal on the back surface is 1/4 or less than that on the front surface. Thus, a method for processing a wafer capable of selectively roughening the back surface of a wafer and suppressing warpage of the wafer due to stress, and a wafer having a sufficiently roughened back surface and having a small warpage can be provided.

## Description

### TECHNICAL FIELD

The present invention relates to a method for processing a wafer, and a wafer.

### BACKGROUND ART

In double-side polishing that is currently performed on a wafer after grinding, there is almost no difference in removal between front and back surfaces, and polishing is performed so as to erase streaks caused by the grinding. Therefore, in most cases, the arithmetic roughness is 0.1 nm or less, and both the front and back surfaces of the wafer tend to be flat.

### CITATION LIST

### PATENT LITERATURE

Patent Document 1: JP 2000-150431 A
Patent Document 2: JP H11-233462 A
Patent Document 3: JP 2002-25950 A
Patent Document 4: JP H09-246220 A
Patent Document 5: JP 2013-45909 A
Patent Document 6: JP 2014-236147 A

### SUMMARY OF INVENTION

### TECHNICAL PROBLEM

When the streaks generated by grinding remain on the front and back surfaces of the wafer, warpage of the wafer generates due to stress of the streaks. There is a demand for a double-side polishing method in which, by using this, an amount of the streaks on the front and back surfaces can be controlled and the shape of a wafer can be controlled by warping to convex or concave shape by polishing the front and back surfaces of the wafer with different polishing removals while maintaining the quality of flatness and nanotopography. Furthermore, as recent customer needs, a wafer with a roughened back surface is desired, for example, since a roughened back surface can reduce the friction between the pins and the wafer in a vacuum pin chuck in a photolithography process. However, in the currently used double-side polishing method, it is not possible to roughen the processed surface to an arithmetic roughness Sa of 0.2 nm or more.

The present invention has been made to solve the above problems, and an object is to provide a method for processing a wafer capable of selectively roughening the back surface of a wafer and suppressing warping of the wafer due to stress, and a wafer with sufficiently roughened the back surface and small warpage.

### SOLUTION TO PROBLEM

In order to solve the above problems, the present invention provides a method for processing a wafer comprising;
surface-grinding front surface of the wafer and back surface opposite to the front surface with a grindstone having a size of 10000 or more, and
double-side polishing both sides of the wafer that has been surface-ground so that removal on the back surface is 1/4 or less than that on the front surface.

According to such a method for processing a wafer, the back surface of the wafer can be selectively roughened, and the warping of the wafer due to stress can be suppressed.

The double-side polishing is preferably performed so that the back surface of the wafer has an arithmetic roughness (Sa) of 1 nm or more in a wavelength range of 10 µm to 100 µm and a Warp of the wafer of 10 µm or less.

According to such a processing method, it is possible to obtain a wafer having a more sufficiently roughened back surface and a sufficiently small warpage.

Further, in the present invention, it provides a wafer having front surface which is a mirror and back surface opposite to the front surface,
wherein, the back surface has an arithmetic roughness (Sa) of 1 nm or more in a wavelength range of 10 µm to 100 µm and a warp of 10 µm or less.

Such a wafer has a sufficiently roughened back surface and a sufficiently small warpage, so that it can exhibit excellent handleability in applications where it is desirable that the back surface of the wafer is roughened.

### ADVANTAGEOUS EFFECTS OF INVENTION

As described above, according to the method for processing a wafer of the present invention, it is possible to selectively roughen the back surface of the wafer and to suppress warpage of the wafer due to stress.

In addition, since the wafer of the present invention has a sufficiently roughened back surface and a sufficiently small warpage, excellent handleability can be exhibited in applications where it is desirable that the back surface of the wafer is roughened, for example, in a vacuum pin chuck in a photolithography process.

### BRIEF DESCRIPTION OF DRAWINGS

FIG. 1 is a schematic diagram illustrating an example of removal in double-side polishing in the method for processing a wafer of the present invention; and
Fig. 2 is a graph showing the relationship between the size of the grindstone used in grinding and the arithmetic roughness (Sa) of the back surface and Warp of the processed wafer in Examples and Comparative Examples.

### DESCRIPTION OF EMBODIMENTS

As described above, there has been a demand for development of a method for processing a wafer capable of selectively roughening the back surface and suppressing the warping of the wafer due to stress, in double-side polishing of a wafer that has been surface-ground.

As a result of intensive studies on the above problems, inventors of the present invention have found that it is possible to roughen only the back surface selectively and to suppress warping of the wafer due to stress, when as a raw material wafer to be used for double-side polishing, a wafer having both the front and back surfaces subjected to very-fine surface-grinding with a grindstone size of 10000 (#10000) or more, and then processing is performed so that the front surface removal during double-side polishing is 4 times or more the back surface removal (the back surface removal is 1/4 times or less than the front surface removal), and completed the present invention.

That is, the present invention is a method for processing a wafer comprising;
surface-grinding front surface of the wafer and back surface opposite to the front surface with a grindstone having a size of 10000 or more, and
double-side polishing both sides of the wafer that has been surface-ground so that removal on the back surface is 1/4 or less than that on the front surface.

Further, the present invention is a wafer having front surface which is a mirror and back surface opposite to the front surface,
wherein, the back surface has an arithmetic roughness (Sa) of 1 nm or more in a wavelength range of 10 µm to 100 µm and a warp of 10 µm or less.

Although there is a method of separately surface-grinding the front and back surfaces under different conditions (for example, Patent Document 1), there are few reports on techniques for roughening the back surface of a wafer by double-side polishing. For example, Patent Documents 2 and 3 disclose that the front and back surfaces are polished under different conditions. Further, Patent Documents 4 to 6 disclose techniques relating to double-side polishing, and disclose provision of wafers with roughened back surfaces. However, none of these documents disclose double-side polishing of a wafer which has been subjected to very-fine surface-grinding with a grindstone size of 10000 or more as in the present invention so that the front and back surfaces have different removal.

Hereinafter, the present invention will be described in detail with reference to the drawings, but the present invention is not limited thereto.

### [Method for processing a wafer]

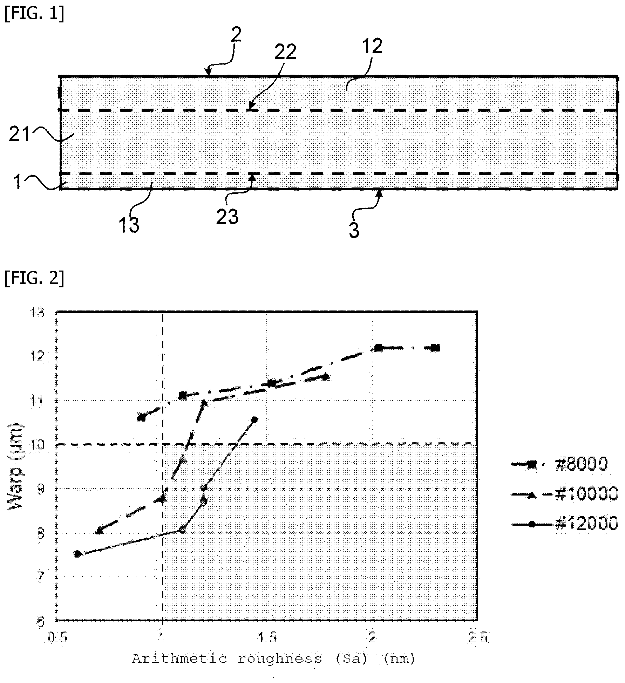

FIG. 1 is a schematic diagram illustrating an example of removal in double-side polishing in the method for processing a wafer of the present invention.

In the method for processing a wafer of the present invention, as shown in FIG. 1, to a wafer which has been subjected to surface-grinding of front surface of the wafer and back surface opposite to the front surface with a grindstone having a size of 10000 or more, double-side polishing is performed so that removal 13 on the back surface 3 is 1/4 or less than removal 12 on the front surface 2. For example, when the removal 12 of the front surface 2 is 40 µm, the removal 13 of the back surface 3 is 10 µm or less. The removal difference can be adjusted by, for example, the rotation speed of the turn tables. Double-side polishing can be, for example, double-side simultaneous polishing. As for the very-fine grinding, both sides may be ground simultaneously, or each side may be ground one by one. Double-side polishing results in a wafer 21 having a front surface 22 and an opposite back surface 23.

According to such a method for processing of the present invention, the back surface 23 of the wafer 21 can be selectively roughened, and the warping of the wafer 21 due to stress can be suppressed. Since the wafer 21 obtained in this manner has a sufficiently rough back surface 23 and a sufficiently small warpage, excellent handleability can be exhibited in applications where it is desirable that the back surface 23 of the wafer is roughened, for example, in a vacuum pin chuck in a photolithography process.

On the other hand, when surface-grinding is performed with a grindstone size of less than 10000, warpage of the wafer cannot be sufficiently suppressed. The upper limit of the size of the grindstone used for surface grinding is not particularly limited, but may be, for example, size of 12000.

If double-side polishing is performed so that the removal 13 on the back surface 3 is larger than 1/4 times the removal 12 on the front surface 2, warpage of the wafer cannot be sufficiently suppressed, or the back surface cannot be sufficiently roughened. Double-side polishing is preferably performed so that the removal 13 on the back surface 3 is 1/20 to 1/4 times the removal 12 on the front surface 2.

In the method for processing a wafer of the present invention, the double-side polishing is preferably performed so that the back surface 23 of the wafer 21 obtained by double-side polishing has an arithmetic roughness (Sa) of 1 nm or more in a wavelength range of 10 µm to 100 µm, and Warp of the wafer 21 of 10 µm or less. Although the upper limit of the arithmetic roughness (Sa) is not particularly limited, the arithmetic roughness (Sa) can be, for example, 1 nm or more and 5 nm or less. The Warp of the wafer 21 is preferably small, but can be, for example, 4 µm or more and 10 µm or less.

Wafers to be processed by the wafer processing method of the present invention are not particularly limited, but silicon wafers can be mentioned for example.

### [Wafer]

FIG. 1 also shows an example of the wafer of the present invention.

A wafer 21 shown in FIG. 1 has front surface 22 which is a mirror and back surface 23 opposite to the front surface 22. In the wafer 21, the back surface 23 has an arithmetic roughness (Sa) of 1 nm or more in the wavelength range of 10 µm to 100 µm. Furthermore, the Warp of the wafer 21 is 10 µm or less. Although the upper limit of the arithmetic roughness (Sa) is not particularly limited, the arithmetic roughness (Sa) can be, for example, 1 nm or more and 5 nm or less. The Warp of the wafer 21 is preferably small, but can be, for example, 4 µm or more and 10 µm or less.

Since such a wafer 21 has a sufficiently roughened back surface 23 and a sufficiently small warpage, excellent handleability can be exhibited in applications where it is desirable that the back surface of the wafer is roughened, for example, in a vacuum pin chuck in a photolithography process.

The wafer of the present invention can be obtained, for example, by the method for processing a wafer of the present invention.

### EXAMPLES

The present invention will be specifically described below using Examples and Comparative Examples, but the present invention is not limited to these.

### (Example 1)

### · Experimental conditions

A 4-way double-side polishing apparatus DSP-20B manufactured by Fujikoshi Machinery Corp. was used as the double-side polishing apparatus. A foamed urethane pad having a Shore A hardness of 90 was used as polishing pad, and a slurry containing silica abrasive grains, an average particle size of 35 nm, abrasive grain concentration of 1.0 wt %, and pH of 10.5 in KOH basis was used.

In Example 1, a plurality of wafers were provided, and the front surface and the back surface of each wafer were surface-ground one by one with a #10000 (size of 10000) grindstone. Next, conditions (rotational speeds of upper and lower turn tables) were changed for each of the surface-ground wafers, and simultaneous double-side polishing was performed to process the wafers. In Example 1, rotation ratio of the upper turn table and the lower turn table was set to two levels of 6:1 and 5:1 so that the removal on the back surface was 1/4 times or less than the removal on the front surface, and double-side polishing was performed.

### (Example 2)

In Example 2, the wafers were processed in the same manner as in Example 1, except that the front and back surfaces of the provided wafers were ground with a #12000 (size of 12000) grindstone. In Example 2, the double-side polishing was performed in conditions that the rotation ratio of the upper turn table and the lower turn table was set to three levels of 6:1, 5:1 and 4:1 so that the removal on the back surface was 1/4 times or less than the removal on the front surface.

### (Comparative example 1)

In Comparative Example 1, the wafers were processed in the same manner as in Example 1, except that double-side polishing was performed under conditions such that the removal on the back surface was larger than 1/4 times the removal on the front surface. In Comparative Example 1, double-side polishing was performed with the rotation ratios of the upper turn table and the lower turn table set to three levels of 3:1, 2:1 and 1.5:1.

### (Comparative example 2)

In Comparative Example 2, the wafers were processed in the same manner as in Example 2, except that double-side polishing was performed under conditions such that the removal on the back surface was larger than 1/4 times the removal on the front surface. In Comparative Example 2, double-side polishing was performed with the rotational speeds of the upper turn table and the lower turn table set to two levels of 3:1 and 2:1.

### (Comparative Example 3)

In Comparative Example 3, a plurality of wafers were provided, and the front and back surfaces of each wafer were surface-ground with a #8000 (size of 8000) grindstone. Next, the wafers subjected to surface grinding were subjected to double-side polishing under different conditions to process the wafers. In Comparative Example 3, double-side polishing was performed with the rotational speeds of the upper turn plate and the lower turn plate set to 5 levels of 6:1, 5:1, 4:1, 3:1 and 2:1.

Each of the processed wafer was subjected to SC-1 cleaning under the conditions of NH₄OH:H₂O₂:H₂O=1:1:15. Warp was measured by using Wafersight 1 of KLA after cleaning, and the arithmetic roughness Sa of the back surface in the wavelength region of 10 µm to 100 µm was measured with 1 mm probing by using SJ-410 of Mitsutoyo.

### [Measurement result]

The measurement results are shown in FIG. 2 as the relationship between the size of the grindstone used in grinding and the arithmetic roughness (Sa) of the back surface and Warp of the wafer after processing in the Examples and Comparative Examples.

From FIG. 2, it can be confirmed that the warpage increases as the arithmetic roughness (Sa) increases. A comparison of sizes 8000 to 12000 shows that warpage (Warp) after double-side polishing can be suppressed most effectively in the case of double-side polishing of a wafer ground with a 12000 size grindstone. Even when wafers ground with a grindstone of 10000 size were double-side polished, it was confirmed that some wafers fell within the region corresponding to the wafers with sufficient back surface roughness and sufficient small warpage shown in gray in FIG. 2.

Specifically, wafers processed in Example 1 (Surface grinding: 10000 size grindstone; Double-side polishing: removal on the back surface being 1/4 times or less than removal on the front surface) and Example 2 (Surface grinding: 12000 size grindstone; Double-side polishing: removal on the back surface being 1/4 times or less than removal on the front surface) fell within the region shown in gray in FIG. 2.

On the other hand, in Comparative Examples 1 and 2 in which surface grinding was performed using 10000 size and 12000 size grindstone, respectively, and double-side polishing was performed so that the removal on the back surface was larger than 1/4 times the removal on the front surface, it was not possible to obtain wafers falling within the region shown in gray in FIG. 2.

In addition, in Comparative Example 3 in which surface grinding was performed with 8000 size, it was possible to achieve roughening, but warpage tend to increase. As shown in FIG. 2, in Comparative Example 3, wafers falling within the region shown in gray in FIG. 2 could not be obtained.

Therefore, it is necessary to grind the surface with a grindstone of size of 10000 or more, and the difference between the front and back surface removal in double-side polishing is set so that the removal on the back surface is 1/4 times or less than the removal on the front surface, so that only the back surface can be sufficiently roughened, and warpage can be sufficiently suppressed.

The present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A method for processing a wafer comprising;
surface-grinding front surface of the wafer and back surface opposite to the front surface with a grindstone having a size of 10000 or more and,
double-side polishing both sides of the wafer that has been surface-ground so that removal on the back surface is 1/4 or less than that on the front surface.

2. The method for processing a wafer according to claim 1,
wherein, the double-side polishing is performed so that the back surface of the wafer has an arithmetic roughness (Sa) of 1 nm or more in a wavelength range of 10 µm to 100 µm and a warp of the wafer of 10 µm or less.

3. A wafer having front surface which is a mirror and back surface opposite to the front surface,
wherein, the back surface has an arithmetic roughness (Sa) of 1 nm or more in a wavelength range of 10 µm to 100 µm and a warp of 10 µm or less.
